# FASCICULE DE BREVET EUROPEEN

(11) **EP 1 602 932 B1**
(45) Date de publication et mention de la délivrance du brevet: **13.05.2009**
(21) Numéro de dépôt: 05290518.9
(22) Date de dépôt: 08.03.2005
(51) Int. Cl.: G01R 1/067, G01D 3/02

(54) **Agencement d'un instrument de mesure avec une famille de capteurs**
Vorrichtung eines Messinstruments mit einer Sensorenfamilie
Arrangement of a measuring instrument with a family of sensors

(30) Priorité: 10.03.2004 FR 0402509
(43) Date de publication de la demande: 07.12.2005
(73) Titulaire: CHAUVIN ARNOUX, Neuilly sur Seine (FR)
(72) Inventeur: Piaud, Didier, 75018 Paris (FR); Pion, Francisque, 75018 Paris (FR)
(74) Mandataire: Thinat, Michel

(56) Documents cités:
- EP-A- 0 974 844
- US-A- 5 347 476
- US-A- 5 375 073
- US-A- 5 396 168
- US-B1- 6 427 129

## Description

L'invention concerne un agencement d'un instrument de mesure avec une famille de capteurs actifs et/ou passifs.

Lorsque l'on emploie un instrument de mesure susceptible d'être utilisé pour différents types de grandeurs à mesurer, par exemple des tensions électriques, des températures, des vitesses de rotation d'une machine, il faut choisir chaque fois le capteur approprié et, surtout, régler l'instrument de mesure selon les caractéristiques de la grandeur à mesurer et les caractéristiques du capteur. Ces réglages sont souvent très complexes ou pour le moins fastidieux. Ils le sont encore davantage, lorsqu'il s'agit de brancher plusieurs capteurs différents sur l'instrument de mesure. De plus, lorsque l'instrument de mesure utilisé est un oscilloscope, les résultats de mesure obtenus moyennant chacun des capteurs sont affichés sur un même écran. Dans ce cas, il est nécessaire de prévoir des moyens permettant d'identifier facilement chacun des résultats affichés à l'écran.

Toutefois, chaque fois que l'on introduit manuellement des caractéristiques d'une sonde, l'utilisateur de l'instrument de mesure court le risque de se tromper et soit endommager l'instrument de mesure, soit afficher un résultat erroné.

Le document US-5,347,476 A décrit un agencement d'un instrument de mesure avec une série de capteurs. L'agencement comprenant un instrument de mesure et des capteurs. Chaque capteur comprend un moyen de traitement de données permettant à l'instrument de mesure d'identifier le capteur.

Le but de l'invention est de proposer un moyen permettant d'éviter les risques énoncés ci-avant.

Le but de l'invention est atteint avec un agencement d'un instrument de mesure avec une famille de capteurs, qui comprend outre l'instrument de mesure et les capteurs, un dispositif de raccordement permettant d'associer l'un quelconque des capteurs à l'instrument de mesure. Ce dispositif de raccordement comporte une alimentation et des dispositifs de mémorisation et de traitement de données permettant d'identifier le capteur, activer la sécurité et transmettre des données sous forme analogique et numérique, ces dispositifs étant déterminés selon les caractéristiques du capteur.

Le dispositif de raccordement comprend également une connectique multipoints dont une première partie est destinée à établir une liaison entre le capteur et le moyen de traitement de données pour un échange de données nécessaire à l'identification du capteur, pour la prise en compte de la sécurité de l'ensemble instrument/capteur et éventuellement pour d'autres fonctions.

Une seconde partie de la connectique multipoints est destinée à établir une liaison de transmission directe et isolée de signaux de mesure du capteur à l'instrument de mesure.

Cet agencement permet d'obtenir pour le moins les fonctionnalités suivantes : connexion de type Plug & Play, c'est-à-dire une connexion ne nécessitant de la part de l'utilisateur que le raccordement des appareils à raccorder entre eux, identification automatique du type de capteur, mise en place d'une sécurité active des utilisateurs vis-à-vis des dangers électriques de l'ensemble capteur/instrument de mesure.

L'agencement selon l'invention permet par ailleurs aussi de compléter ces fonctionnalités utiles et nécessaires par des fonctionnalités supplémentaires pratiques tels qu'un moyen de télécommande embarqué sur le capteur ou la fonction d'éclairage de la zone de travail des capteurs.

Dans le cadre de la présente invention, nous désignons indifféremment comme capteur tous composant, dispositif, moyen, sonde adaptateur et bien d'autres, destinés à être installés ou posés ou tenus temporairement à un endroit où une grandeur physique telle une tension électrique, une température, un champ magnétique, une pression et bien d'autres doit être mesurée.

Comme instrument de mesure, nous considérons dans le cadre de la présente invention plus particulièrement les oscilloscopes, sans exclure pour autant des instruments de mesure conçus pour afficher des grandeurs physiques sur un écran d'affichage tel un écran graphique ou alpha numérique ou sur un support papier moyennant une imprimante.

Lorsque l'on utilise un instrument de mesure simple tel un multimètre conçu pour mesurer des tensions électriques, des courants électriques et des résistances ohmiques, il est suffisant que l'utilisateur branche deux câbles par une de leurs extrémités sur l'instrument de mesure, dans des bornes prévues à cet effet, et tient les deux câbles par l'autre de leurs extrémités, habituellement équipées de pointes, sur deux points entre lesquels la grandeur physique doit être mesurée. Pour obtenir le bon résultat, d'une part, et pour éviter que l'instrument de mesure soit endommagé, d'autre part, l'utilisateur a préalablement choisi la bonne gamme de mesure moyennant un bouton sélecteur approprié.

Pour ces instruments de mesure habituels, il n'est pas nécessaire de prévoir des protections actives pour protéger l'utilisateur, car, en général, les pointes de mesure avec lesquelles les câbles sont équipés fournissent une protection suffisante.

Cependant, lorsqu'il s'agit de mesurer des grandeurs physiques tels que des champs magnétiques, des tensions électriques élevées ou des courants électriques forts, ou lorsque l'on mesure des grandeurs physiques par échantillonnage, cette sécurité passive n'est en général pas suffisante. En effet, la capacité de mesure d'un instrument de mesure ou d'un capteur peut être limitée à certains modes d'opération, par exemple à différentes tensions de mesure selon le mode d'opération choisi. Si l'utilisateur de l'instrument de mesure s'approche de telles limites, il est nécessaire de pouvoir prévenir l'utilisateur du risque qu'il pourrait encourir ou faire encourir à l'instrument.

Ainsi, dans ce qui est appelé la sécurité active, l'instrument de mesure affiche dans une fenêtre fugitive les limites de l'ensemble capteur/instrument. Un système de vérification de la conformité de la grandeur physique, notamment de la grandeur électrique correspondante venant du capteur, par rapport à la limite fixée permet l'émission d'une alarme lorsqu'il y a dépassement. Il s'agit donc d'une protection intelligente.

En effet, pour ces types de mesures, il est nécessaire que l'utilisateur de l'instrument de mesure s'assure en permanence que l'instrument de mesure soit réglé à la bonne gamme de grandeurs physiques, que le capteur choisi corresponde à la gamme de grandeurs physiques à mesurer et que le capteur soit convenablement relié à l'instrument de mesure.

L'agencement selon l'invention y répond avec les moyens indiqués plus haut de la manière décrite ci-après en référence aux dessins. Dans ces dessins, il est représenté un mode de réalisation de l'agencement selon l'invention. Ces dessins montrent en particulier :
Figure 1 : un capteur avec un dispositif de raccordement,
Figure 2 : le capteur en une vue en perspective du côté de la pointe du capteur,
Figure 3 : le dispositif de raccordement selon l'invention en une vue en perspective, et
Figure 4 : le schéma électrique d'un dispositif selon l'invention.

L'agencement selon l'invention comprend, outre un instrument de mesure 20, un capteur 1 et un dispositif de raccordement 10 moyennant lequel le capteur 1 est raccordé à l'instrument de mesure 20.

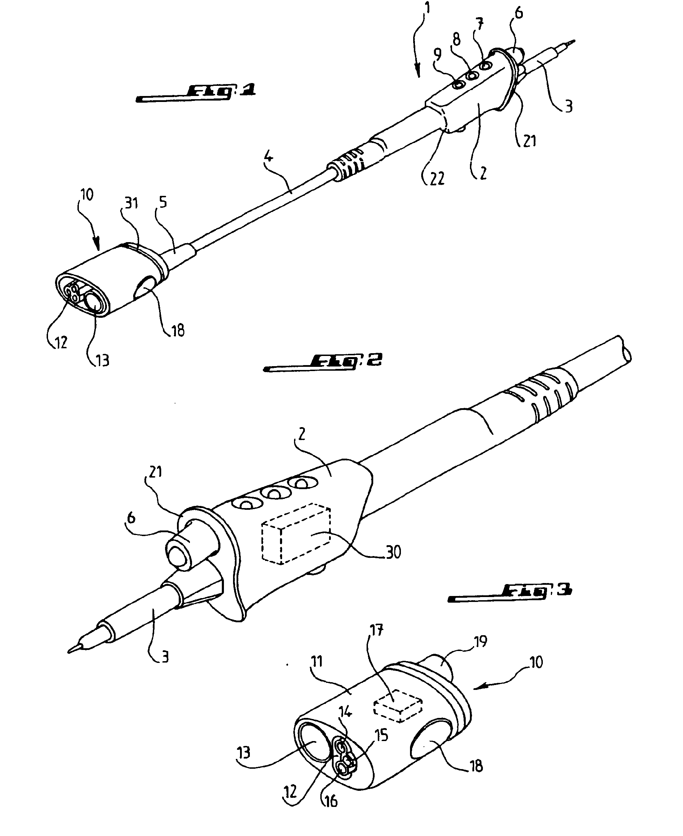

Le capteur 1 représenté sur les figures 1 et 2 comprend un boîtier 2 de forme générale cylindrique avec deux extrémités 21, 22. Du côté de l'extrémité 21, le capteur 1 est muni d'une pointe de mesure 3 et du côté de l'extrémité 22, le capteur 1 est muni d'un câble de liaison 4 lequel se termine du côté opposé par rapport au boîtier 2 du capteur 1 par un connecteur 5. Le capteur 1 comprend également une lampe 6 disposée sur l'extrémité 21 du boîtier 2 du capteur 1 et destinée à éclairer la zone de travail du capteur. Sur la face supérieure du boîtier 2, le capteur 1 est pourvu de trois boutons de commande 7, 8, 9 correspondant à des contacts électriques permettant à l'utilisateur d'activer des fonctions particulières, comme cela sera expliqué plus loin, lors de la connexion. Un de ces contacts électriques, actionné par le bouton de commande correspondant, peut servir à allumer et éteindre la lampe 6. Les autres fonctions peuvent être choisies sur l'instrument de mesure.

Le dispositif de raccordement 10 comprend un moyen de gestion 17 avec une mémoire permettant de déterminer, à partir de données enregistrées dans cette mémoire, des caractéristiques des mesures à faire, telles que la nature du signal à mesurer, l'unité de mesure, un coefficient d'échelle de la sonde, et des données de compensation.

Le capteur 1 comprend par ailleurs une mémoire 30 contenant les indications nécessaires à son identification automatique pour l'instrument de mesure. Pour les instruments de mesure comprenant un écran couleurs d'affichage, la mémoire 30 donne aussi l'indication de la couleur attribuée à ce capteur comme couleur de reconnaissance afin que les résultats de mesure du capteur soient affichés en sensiblement la même couleur que celle qui lui est attribuée. La couleur attribuée au capteur particulier est alors matérialisée avantageusement par une pièce colorée amovible et donc remplaçable en cas de changement de la couleur attribuée. Cette pièce est fixée soit du côté du raccordement soit du côté de son extrémité préhensible. L'attribution initiale d'une couleur et tout changement de cette attribution sont entrés respectivement par le fabricant et par l'utilisateur de l'instrument de mesure de façon à mettre en concordance couleur physique et couleur informatique.

Afin que les capacités particulières des capteurs selon l'invention puissent être exploitées, le capteur 1 est raccordé à l'instrument de mesure moyennant un dispositif de raccordement 10 selon l'invention.

Le dispositif de raccordement 10 comprend, comme représenté sur la figure 3, un boîtier 11 dans lequel est logé un moyen de traitement et de stockage de données 17, ainsi qu'une connectique multipoints 12, 13.

Le moyen de traitement et de stockage de données 17 permet d'identifier le capteur 1 et permet également, le cas échéant, l'affichage d'informations nécessaires à la sécurité active de l'ensemble instrument/capteur selon les caractéristiques du capteur.

La première partie 12 de la connectique multipoints est destinée à établir une liaison entre le capteur 1 et le moyen de traitement et de stockage de données 17 pour un échange de données nécessaire à l'identification du capteur 1 et à l'affichage d'informations nécessaires à la sécurité active de l'ensemble instrument/capteur et éventuellement d'autres fonctions.

La première partie 12 de la connectique multipoints comprend un raccordement avec trois lignes 14, 15 et 16. Cette première partie peut être réalisée en fonction du nombre de lignes à passer et les connecteurs les plus pratiques pour l'application particulière. Les trois lignes servent en général pour la masse de la transmission de signaux, pour les signaux et pour l'horloge. En même temps, l'alimentation électrique du capteur 1 permet la transformation, dans le capteur, de certains résultats, par exemple la transformation d'un courant mesuré ou d'une température mesurée en un signal de tension.

La seconde partie 13 de la connectique multipoints est destinée à établir une liaison de transmission directe et isolée diélectriquement de la première partie, des signaux de mesure du capteur 1 à l'instrument de mesure 20. Elle est réalisée en général comme connexion coaxiale standardisée 50 Ω dont la masse est séparée de celle de la première partie 12. Le dispositif de raccordement 10 est ainsi conçu de façon que d'autres sondes que celles spécialement assorties à l'instrument de mesure 20 peuvent également être utilisées. Toutefois, lorsque l'on utilise de tels capteurs généralement disponibles, on renonce aux avantages apportés par la présente invention.

Le dispositif de raccordement 10 comprend sur le côté opposé par rapport à la multiconnectique, une fiche 19 spécifiquement adaptée au connecteur 5 de la sonde 1.

Le dispositif de raccordement 10 est équipé par ailleurs de deux commandes mécaniques 18 destinées à assurer un branchement du dispositif de raccordement 10 à l'instrument de mesure 20 par encliquetage. Ces moyens ne sont pas représentés en détails pour ne pas surcharger la description ni les figures.

De même, le dispositif de raccordement 10 détecte la déconnexion d'un capteur 1, la fonction d'identification du capteur et l'activation d'au moins une fonction de protection de l'utilisateur de l'instrument de mesure déterminée selon les caractéristiques du capteur n'étant effectuées qu'à la suite d'une détection de rupture.

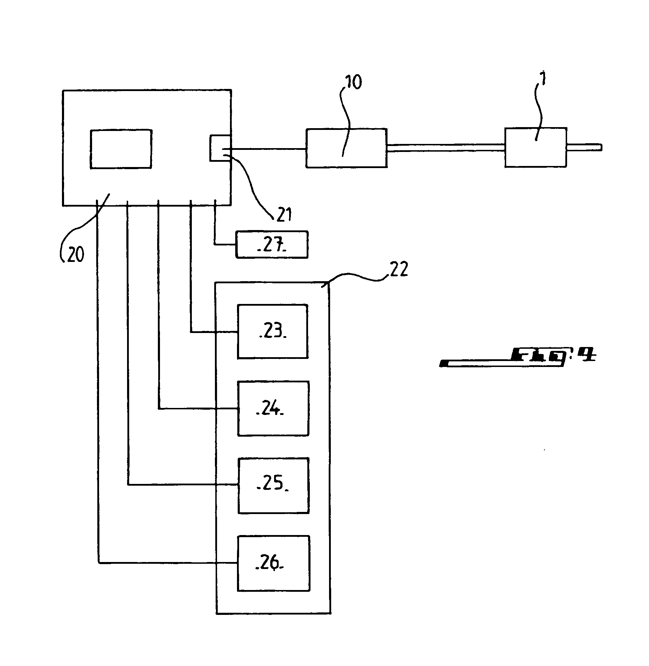

L'agencement selon l'invention comprend, comme représenté sur la figure 4, un moyen de gestion 27 des capacités de mesure et d'affichage de l'instrument de mesure 20. Ce moyen de gestion 27, par exemple sous la forme d'un microprocesseur, surveille que le calibrage de l'instrument de mesure correspond au capteur 1 utilisé et détermine en même temps les moyens d'affichage et d'information nécessaires à l'information de l'utilisateur de l'instrument de mesure. Il comprend avantageusement également un détecteur de rupture destiné à détecter, comme mentionné au paragraphe précédent, la déconnexion d'un capteur 1.

En effet, pour ne pas surcharger la ligne de transmission de données, pour éviter une scrutation permanente du ou des bus de service et donc pour éviter l'activité électrique sur le ou les bus pendant les mesures, car cette activité peut être préjudiciable pour certaines mesures, et en même temps pour éviter une perte de temps machine pour la scrutation, la configuration de la voie de transmission des données et des mesures de protection de l'utilisateur est initialisée uniquement lorsqu'un signal d'interruption est envoyé de la sonde 1 à l'instrument de mesure 20.

Ainsi, lorsqu'un capteur 1 est raccordé à l'instrument de mesure 20 moyennant le dispositif de raccordement 10, l'instrument de mesure est réglé automatiquement selon le type de capteur utilisé. La lecture du contenu de la mémoire 17 du capteur dans laquelle sont enregistrées toutes les caractéristiques nécessaires au bon fonctionnement du capteur et de l'instrument de mesure, est déclenchée par le raccordement. Il en découle plus particulièrement la mise en route de la voie de transmission de données correspondante, la détermination de la nature du signal à mesurer, la détermination de l'unité de mesure et d'un coefficient d'échelle de la sonde et la détermination des périodes de recalibrage. De plus, s'il n'y a pas de conformité entre la grandeur mesurée et la limite fixée, une alarme est déclenchée.

L'agencement selon l'invention comprend par ailleurs un moyen d'information 22 permettant de mettre à la disposition de l'utilisateur de l'instrument de mesure 20 les informations nécessaires à la sécurité active de l'ensemble formé par l'instrument de mesure 20 et le capteur 1, et les résultats des mesures effectuées moyennant le capteur 1.

Ainsi, le moyen d'information 22 comprend par exemple un écran d'affichage numérique 23 destiné à l'affichage des informations nécessaires à la sécurité active de l'ensemble instrument de mesure / capteur. Le moyen d'information 22 est par ailleurs relié à un moyen d'affichage graphique des résultats de mesure. Cette liaison permet d'afficher les informations nécessaires à la sécurité active de l'ensemble instrument de mesure/capteur soit avant l'affichage des résultats de mesure, soit de manière répétée, à des périodes prédéterminées ou variables, pendant l'affichage des résultats de mesure. Cet affichage des informations peut être effectué soit en réponse à une commande effectuée par le moyen d'information, par exemple de manière cyclique, ou à chaque début d'une série de mesure ou encore en réponse à une commande manuelle déclanchée par l'utilisateur de l'instrument de mesure 20.

Le moyen d'information 22 peut également comprendre une imprimante couleurs 26 permettant une présentation graphique et alphanumérique des résultats de mesure sur un support durable tel que du papier. Le moyen d'information 22 peut également comprendre un écran 25 permettant à la fois un affichage graphique et un affichage alphanumérique des résultats de mesure.

Dans l'énoncé ci-avant les différents moyens d'information, l'écran d'affichage alphanumérique 23, le moyen d'affichage graphique 24, l'écran couleur 25 et l'imprimante 26, sont donnés à titre d'exemple de moyens d'information habituellement utilisés. La formulation "peut comprendre" a été utilisée pour indiquer que celui qui met la présente invention en oeuvre, peut choisir librement le moyen d'information qui répond au mieux aux mesures particulières à effectuer et que le choix de l'un de ces moyens ou de plusieurs de ces moyens à utiliser simultanément ou encore d'un autre moyen d'information est indifférent et ne sort pas du principe de la présente invention.

L'agencement selon l'invention comprend par ailleurs des moyens permettant d'activer une fonction à choisir parmi un panel prédéfini de fonctions. Ce moyen fonctionne avantageusement par interruption de la liaison électrique entre le capteur 1 et l'instrument de mesure 20. Les moyens peuvent inclure notamment les contacts électriques 7, 8 et 9 et les boutons de commande correspondants disposés sur le boîtier 2 de la sonde 1. Cette possibilité s'ajoute à la commande automatique selon laquelle l'identification du capteur et le calibrage de l'instrument de mesure selon la sonde sont automatiquement effectués. Cette possibilité supplémentaire permet d'utiliser des sondes à capacités multiples tout aussi bien que de commander l'agencement pendant son utilisation selon différentes façons de mesurer, par exemple pour différents types d'échantillonnage.

## Revendications

1. Agencement d'un instrument de mesure (20) avec une famille de capteurs actifs et/ou passifs (1), l'agencement comprenant, outre l'instrument de mesure (20) et les capteurs (1), un dispositif de raccordement (10) permettant d'associer l'un des capteurs (1) à l'instrument de mesure, **caractérisé en ce que** le dispositif de raccordement (10) est conformé pour être relié au capteur (1) et pour le relier à l'instrument de mesure (20) et comporte à cet effet une fiche (19) adaptée à un connecteur (5) de la sonde (1) et une connectique multipoints (12, 13) en deux parties diélectriquiement isolées l'une (12) de l'autre (13), le dispositif de raccordement (10) comprenant en outre un moyen de traitement de données (17) conformé pour pouvoir identifier le capteur (1) et pour activer au moins une fonction de protection de l'utilisateur de l'instrument de mesure (20) déterminée selon les caractéristiques du capteur, la connectique multipoints (12, 13) comportant une première partie (12) destinée à établir une liaison entre le capteur (1) et le moyen de traitement de données (17) pour un échange de données nécessaires à l'identification du capteur (1) et pour l'activation de la protection et éventuellement d'autres fonctions, et une seconde partie (13) destinée à établir une liaison de transmission directe de signaux de mesure du capteur (1) à l'instrument de mesure (20).

2. Agencement selon la revendication 1, **caractérisé en ce qu'**il comprend un moyen de gestion (27) des capacités de mesure et d'affichage de l'instrument de mesure (20) selon le capteur (1) choisi, ce moyen de gestion étant disposé dans l'instrument de mesure (20).

3. Agencement selon la revendication 1 ou 2, **caractérisé en ce qu'**il comprend un moyen d'information (22) permettant de mettre à la disposition de l'utilisateur des informations nécessaires à la sécurité active de l'ensemble instrument de mesure/capteur et les résultats de mesure.

4. Agencement selon la revendication 3, **caractérisé en ce que** le capteur (1) comprend une lampe (6) disposée sur une extrémité (21) du boîtier (2) du capteur (1) et destinée à éclairer la zone de travail du capteur.

5. Agencement selon la revendication 3, **caractérisé en ce que** le moyen d'information (22) est relié à un moyen d'affichage graphique (24) des résultats de mesure, cette liaison permettant d'afficher les informations nécessaires à la sécurité active de l'ensemble instrument de mesure / capteur avant l'affichage des résultats de mesure ou de manière répétée pendant l'affichage des résultats de mesure, selon une commande effectuée par le moyen d'information (22).

6. Agencement selon l'une quelconque des revendications 1 à 5, **caractérisé en ce que** le capteur (1) comprend par ailleurs une mémoire (30) contenant les indications nécessaires à son identification automatique pour l'instrument de mesure et aussi l'indication de la couleur attribuée à ce capteur comme couleur de reconnaissance afin que les résultats de mesure du capteur soient affichés en sensiblement la même couleur que celle qui lui est attribuée.

7. Agencement selon l'une quelconque des revendications 1 à 6, **caractérisé en ce que** le dispositif de raccordement (10) comprend un moyen de gestion (17) avec une mémoire permettant de déterminer, à partir de données enregistrées dans cette mémoire, des caractéristiques des mesures à faire, telles que la nature du signal à mesurer, l'unité de mesure, un coefficient d'échelle de la sonde, et des données de compensation.

8. Agencement selon l'une quelconque des revendications 1 à 7, **caractérisé en ce qu'**il comprend un moyen de gestion (2.) des périodes de re-calibration de l'instrument de mesure (20).

9. Agencement selon l'une quelconque des revendications 1 à 8, **caractérisé en ce que** le dispositif de raccordement (10) comprend un détecteur de rupture destiné à détecter la déconnexion d'un capteur (1), la fonction d'identification du capteur et l'activation d'au moins une fonction de protection de l'utilisateur de l'instrument de mesure déterminée selon les caractéristiques du capteur n'étant effectuées qu'à la suite d'une détection de rupture.

10. Agencement selon l'une quelconque des revendications 1 à 9, **caractérisé en ce que** le capteur (1) est pourvu de contacts électriques (7, 8, 9) permettant d'activer une fonction de mesure à choisir parmi un panel prédéfini de fonctions, par envoi d'un signal d'interruption de la liaison électrique afférente par le capteur (1) à l'instrument de mesure (20) lors de la connexion.

11. Agencement selon l'une quelconque des revendications 1 à 10, **caractérisé en ce que** chacun des capteurs (1) est pourvu d'un attribut coloré matérialisé par une pièce amovible (31).

## Claims

1. An arrangement of a measuring instrument (20) with a family of active and/or passive sensors (1), the arrangement comprising, besides the measuring instrument (20) and the sensors (1), a connecting device (10) allowing for one of the sensors (1) to be assigned to the measuring instrument, **characterized in that** the connecting device (10) is configured to be linked to the sensor (1) and for linking it to the measuring instrument (20), and comprises therefore a plug (19) adapted to a connector (5) of the probe (1) and multipoint connections (12, 13) composed of two parts dielectrically isolated one (12) from the other (13), the connecting device (10) further comprising a data processing means (17) configured to be able to identify the sensor (1) and activate at least one function for protecting the user of the measuring instrument (20), said function being determined according to the characteristics of the sensor, the multipoint connections (12, 13) having a first part (12) for establishing a link between the sensor (1) and the data processing means (17) for exchanging data required for identification of the sensor (1) and for activation of the protective function and possibly other functions, and a second part (13) for establishing a link for direct transmission of measuring data from the sensor (1) to the measuring instrument (20).

2. The arrangement according to claim 1, **characterized in that** it comprises a means (27) for managing measuring and display capacities of the measuring instrument (20) according to the sensor (1) chosen, the management means being disposed inside the measuring instrument (20).

3. The arrangement according to claim 1 or 2, **characterized in that** it comprises an information means (22) allowing to provide the user with information required for the active security of the measuring instrument/sensor arrangement and with the measuring results.

4. The arrangement according to claim 3, **characterized in that** the sensor (1) comprises a light (6) disposed at one end (21) of the case (2) of the sensor (1) and designed for illuminating the working area of the sensor.

5. The arrangement according to claim 3, **characterized in that** the information means (22) is linked to a means (24) for graphically displaying the measuring results, the link allowing to display the information required for the active security of the measuring instrument/sensor arrangement before displaying the measuring results, or repeatedly while the measuring results are being displayed, depending on an order executed by the information means (22).

6. The arrangement according to any of claims 1 to 5, **characterized in that** the sensor (1) further comprises a memory (30) containing the indications required for automatic identification thereof for the measuring instrument as well as the indication of the color assigned to this sensor as a recognition color so that the measuring results of the sensor are displayed in substantially the same color as the one assigned thereto.

7. The arrangement according to any of claims 1 to 6, **characterized in that** the connecting device (10) comprises a management means (17) having a memory allowing to determine, from the data recorded in said memory, characteristics of the measurements to be taken, such as the nature of the signal to be measured, the unit of measurement, a scaling factor of the probe, and compensation data.

8. The arrangement according to any of claims 1 to 7, **characterized in that** it comprises a means (2) for managing recalibration periods of the measuring instrument (20).

9. The arrangement according to any of claims 1 to 8, **characterized in that** the connecting device (10) comprises a separation detector for detecting the disconnection of a sensor (1), the identification function of the sensor and the activation of at least one function for protecting the user of the measuring instrument, determined according to the characteristics of the sensor, being executed only following a detection of separation.

10. The arrangement according to any of claims 1 to 9, **characterized in that** the sensor (1) is provided with electric contacts (7, 8, 9) allowing to activate a measuring function to be chosen from a predefined group of functions, by sending an interrupt signal of the relevant electric link through the sensor (1) to the measuring instrument (20) during connection.

11. The arrangement according to any of claims 1 to 10, **characterized in that** each of the sensors (1) is provided with a color attribute embodied in a removable part (31).

## Patentansprüche

1. Anordnung eines Messinstruments (20) mit einer Familie von aktiven und/oder passiven Sensoren (1), wobei die Anordnung außer dem Messinstrument (20) und den Sensoren (1) eine Anschlussvorrichtung (10) umfasst, die es ermöglicht, einen der Sensoren (1) dem Messinstrument zuzuordnen, **dadurch gekennzeichnet, dass** die Anschlussvorrichtung (10) ausgestaltet ist, um mit dem Sensor (1) verbunden zu werden und um diesen mit dem Messinstrument (20) zu verbinden, und dazu einen Stecker (19), an ein Verbindungsstück (5) der Sonde (1) angepasst ist, und Mehrpunktanschlüsse (12, 13) aus zwei Teilen, die dielektrisch voneinander (12, 13) getrennt sind, umfasst, wobei die Anschlussvorrichtung (10) ferner ein Datenverarbeitungsmittel (17) umfasst, das ausgestaltet ist, um den Sensor (1) identifizieren zu können und um mindestens eine Funktion zum Schutz des Benutzers des Messinstruments (20) zu aktivieren, die gemäß den Kennzeichen des Sensors bestimmt wird, wobei die Mehrpunktanschlüsse (12, 13) einen ersten Teil (12) zum Aufbauen einer Verbindung zwischen dem Sensor (1) und dem Datenverarbeitungsmittel (17) für einen Austausch von Daten, die zum Identifizieren des Sensors (1) und zum Aktivieren der Schutzfunktion und eventuell von anderen Funktionen notwendig sind, und einen zweiten Teil (13) zum Aufbauen einer Verbindung zum direkten Übertragen von Messdaten vom Sensor (1) zum Messinstrument (20) umfasst.

2. Anordnung nach Anspruch 1, **dadurch gekennzeichnet, dass** sie ein Mittel (27) zum Steuern der Mess- und Anzeigefähigkeiten des Messinstruments (20) gemäß dem gewählten Sensor (1) umfasst, wobei das Steuermittel in dem Messinstrument (20) angeordnet sind.

3. Anordnung nach Anspruch 1 oder 2, **dadurch gekennzeichnet, dass** sie ein Informationsmittel (22) umfasst, das es ermöglicht, dem Benutzer Informationen, die für die aktive Sicherheit der Messinstrument/SensorAnordnung notwendig sind, und die Messergebnisse bereitzustellen.

4. Anordnung nach Anspruch 3, **dadurch gekennzeichnet, dass** der Sensor (1) eine Leuchte (6) umfasst, die an einem Ende (21) des Gehäuses (2) des Sensors (1) angeordnet und dazu gedacht ist, den Arbeitsbereich des Sensors zu beleuchten.

5. Anordnung nach Anspruch 3, **dadurch gekennzeichnet, dass** das Informationsmittel (22) mit einem Mittel (24) zum graphischen Anzeigen der Messergebnisse verbunden ist, wobei es diese Verbindung ermöglicht, die Informationen anzuzeigen, die für die aktive Sicherheit der Messinstrument/Sensor-Anordnung notwendig sind, bevor die Messergebnisse angezeigt werden oder wiederholt während der Anzeige der Messergebnisse, in Abhängigkeit von einem Befehl, der von dem Informationsmittel (22) ausgeführt wird.

6. Anordnung nach einem der Ansprüche 1 bis 5, **dadurch gekennzeichnet, dass** der Sensor (1) ferner einen Speicher (30) umfasst, der die Angaben enthält, die zu seiner automatischen Identifizierung für das Messinstrument notwendig sind, so wie die Angabe der Farbe, die diesem Sensor als Erkennungsfarbe zugewiesen ist, damit die Messergebnisse des Sensors im Wesentlichen in der gleichen Farbe wie die ihm zugewiesene angezeigt werden.

7. Anordnung nach einem der Ansprüche 1 bis 6, **dadurch gekennzeichnet, dass** die Anschlussvorrichtung (10) ein Steuermittel (17) umfasst, mit einem Speicher, der es ermöglicht, aus den in diesem Speicher aufgezeichneten Daten Kennzeichen der vorzunehmenden Messungen zu bestimmen, wie etwa die Art des zu messenden Signals, die Maßeinheit, einen Maßstabfaktor der Sonde und Ausgleichsdaten.

8. Anordnung nach einem der Ansprüche 1 bis 7, **dadurch gekennzeichnet, dass** sie ein Mittel (2) zum Steuern der Zeiträume zum Neukalibrieren des Messinstruments (20) umfasst.

9. Anordnung nach einem der Ansprüche 1 bis 8, **dadurch gekennzeichnet, dass** die Anschlussvorrichtung (10) einen Trennungsdetektor umfasst, um das Abschalten eines Sensors (1) zu erfassen, wobei die Identifizierungsfunktion des Sensors und die Aktivierung von mindestens einer Funktion zum Schutz des Benutzers des Messinstruments, die gemäß den Kennzeichen des Sensors ausgewählt wird, nur nach einer Trennungserfassung ausgeführt werden.

10. Anordnung nach einem der Ansprüche 1 bis 9, **dadurch gekennzeichnet, dass** der Sensor (1) mit elektrischen Kontakten (7, 8, 9) versehen ist, die es ermöglichen, eine Messfunktion zu aktivieren, die aus einer vorgegebenen Funktionsgruppe zu wählen ist, indem ein Unterbrechungssignal der betreffenden elektrischen Verbindung durch den Sensor (1) an das Messinstrument (20) während der Verbindung gesendet wird.

11. Anordnung nach einem der Ansprüche 1 bis 10, **dadurch gekennzeichnet, dass** jeder der Sensoren (1) mit einem Farbattribut versehen ist, das als abnehmbares Teil (31) realisiert ist.
